(19) Europäisches Patentamt / European Patent Office / Office européen des brevets

(11) **EP 3 182 147 B1**

(12) **EUROPÄISCHE PATENTSCHRIFT**

(45) Veröffentlichungstag und Bekanntmachung des Hinweises auf die Patenterteilung:
**28.03.2018 Patentblatt 2018/13**

(51) Int Cl.:
**G01R 33/3873** (2006.01)     *G01R 33/3815* (2006.01)

(21) Anmeldenummer: **16202858.3**

(22) Anmeldetag: **08.12.2016**

(54) **LEICHT ZUGÄNGLICHE TIEFGEKÜHLTE NMR SHIM-ANORDNUNG**

READILY ACCESSIBLE DEEP COOLED NMR SHIM ASSEMBLY

SYSTÈME SHIM RMN RÉFRIGÉRÉ FACILEMENT ACCESSIBLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **17.12.2015 DE 102015225731**

(43) Veröffentlichungstag der Anmeldung:
**21.06.2017 Patentblatt 2017/25**

(73) Patentinhaber: **Bruker BioSpin AG**
**8117 Fällanden (CH)**

(72) Erfinder:
• **Grossniklaus, Beat**
**8173 Neerach (CH)**
• **Kübler, Günter**
**8132 Egg (CH)**
• **Bovier, Pierre-Alain**
**8050 Zürich (CH)**

(74) Vertreter: **Kohler Schmid Möbus Patentanwälte Partnerschaftsgesellschaft mbB**
**Gropiusplatz 10**
**70563 Stuttgart (DE)**

(56) Entgegenhaltungen:
**DE-A1-102012 220 126     JP-A- 2000 037 366**
**US-A1- 2008 191 698**

## Beschreibung

Die Erfindung betrifft eine NMR-Apparatur mit einem supraleitenden Magnetspulensystem zur Erzeugung eines homogenen Magnetfeldes in Richtung einer z-Achse, wobei das Magnetspulensystem in einem He-Behälter mit einem He-Innenrohr, der im Betrieb flüssiges Helium zur Kühlung der Spulen enthält, angeordnet und mechanisch starr mit dem He-Behälter verbunden ist, wobei ein Strahlungsschild mit einem Strahlungsschild-innenrohr den He-Behälter zur Reduzierung der Verdampfungsrate des flüssigen Heliums mit Abstand umgibt, und wobei im Raum zwischen dem He-Innenrohr und dem Strahlungsschildinnenrohr eine Feldformvorrichtung aus weichmagnetischem Material zum Shimmen des homogenen Magnetfeldes angeordnet ist.

Eine solche Anordnung ist bekannt aus der JP 3737636 B2.

Hintergrund der Erfindung

Das Einsatzgebiet von supraleitenden Magnetsystemen umfasst verschiedene Anwendungsfelder, insbesondere Magnetresonanzverfahren. Um in solchen Verfahren eine gute Auflösung zu erreichen, muss das Magnetfeld im Probenvolumen eine hohe Homogenität aufweisen. Mit der geometrischen Anordnung der felderzeugenden Magnetspulen kann die Grundhomogenität des supraleitenden Magneten optimiert werden.

Häufig werden zur Verbesserung der Magnetfeldhomogenität Aussparungen in den Magnetspulen vorgesehen (sogenannte Notchstrukturen), in denen kein Draht gewickelt wird. So geht jedoch wertvoller Platz für Magnetwicklungen verloren, was den Magneten verteuert und das Streufeld vergrößert. In einer Anordnung gemäß US 6,617,853 B2 wird ein supraleitender Magnet für hochauflösende Spektroskopie dadurch kompakter gestaltet, dass ein oder mehrere weichmagnetische Ringe vorgesehen sind, welche die Rolle gewisser Notchstrukturen in den Magnetspulen übernehmen.

Die z-Komponente des Magnetfelds einer Anordnung gemäß US 6,617,853 B2 kann im Probenvolumen nach Kugelfunktionen entwickelt werden:

$$B_z(r, z, \varphi) = \sum_{n=0}^{\infty} \sum_{m=0}^{n} P_n^m \left( \frac{z}{\sqrt{r^2 + z^2}} \right) (r^2 + z^2)^{n/2} \left( A_{nm} \cos(m\varphi) + B_{nm} \sin(m\varphi) \right),$$

wobei nach Design die Koeffizienten $A_{nm}$ mit $m \neq 0$ und alle Koeffizienten $B_{nm}$ verschwinden. Aufgrund von Fertigungstoleranzen in der Magnetanordnung weichen die Koeffizienten $A_{nm}$ und $B_{nm}$ vom berechneten Wert ab. Üblicherweise sind zur Korrektur dieser nicht verschwindenden Koeffizienten Shimspulen vorgesehen, die je mit einem eigenen Strom gespeist werden können. Bei großen Abweichungen der Koeffizienten von ihrem Sollwert kann es vorkommen, dass der in gewissen Shimspulen benötigte Strom zu hoch ist und das Magnetfeld der Magnetanordnung nicht wie gewünscht korrigiert werden kann. Alternativ dazu kann es vorkommen, dass der problematische Koeffizient in der Entwicklung des Magnetfelds nach Kugelfunktionen nicht korrigiert werden kann, weil gar keine Shimspule dafür vorgesehen ist. In einer solchen Situation ist eine teure Reparatur des Magnetsystems erforderlich, bei der ein Teil der Magnetanordnung ersetzt werden muss.

Um die Magnetfeldhomogenität zu verbessern, ohne neue Magnetspulen zu wickeln, können geeignete Feldformvorrichtungen aus weichmagnetischem Material vorgesehen werden.

In der DE 10 16 505 A1 sind verschiedene Arten von Feldformvorrichtungen aus Blech oder Folien beschrieben. Spezialfälle, bei denen das Blech oder die Folien herausgeschnittene rechteckige Fenster aufweisen, werden in der JP 4384220 B2 aufgeführt. Nicht durchgängige Löcher im Blech sind zudem in der DE 10 2012 220 126 A1 offenbart.

Speziell geformte Feldformvorrichtungen können auch den Zweck haben, in supraleitenden Magnetspulen auf die oben beschriebenen Notchstrukturen zu verzichten, um den Magneten kompakter zu gestalten, wie etwa in der DE 10 104 054 C1 erklärt wird.

In der eingangs zitierten JP 3737636 B2 wird ein weiterer wichtiger Aspekt von Feldformvorrichtungen diskutiert: Die Sättigungsmagnetisierung des weichmagnetischen Materials ist temperaturabhängig. Diese Abhängigkeit ist bei hohen Temperaturen, wie zum Beispiel bei Raumtemperatur, besonders ausgeprägt. Kleine Temperaturschwankungen der Feldformvorrichtung bewirken dann aufgrund der variablen Sättigungsmagnetisierung eine Feldänderung im Arbeitsvolumen, die die NMR-Messung beeinträchtigen kann.

Um dem entgegenzuwirken, wird vorgeschlagen, die Feldformvorrichtung im He-Behälter anzubringen. Durch die tiefe Temperatur der Feldformvorrichtung und deren Kühlung durch das flüssige Helium werden ideale Voraussetzungen für stabile Verhältnisse geschaffen. Da jedoch die Feldformvorrichtung erst nach dem Ausmessen des Feldes im Arbeitsvolumen dimensioniert werden kann, muss der Kryostat nach einem ersten Magnettest aufgewärmt und komplett zerlegt werden, bevor die Feldformvorrichtung in den He-Behälter montiert werden kann. Ein solcher Arbeitsschritt kostet Zeit und Geld.

Auch die DE 10 2012 220 126 A1 schlägt als eine mögliche Lösung eine Kühlung der Feldformvorrichtung auf die Temperatur des flüssigen Heliums, um damit die magnetischen Eigenschaften der Feldformvorrichtung zu verbessern. Als Alternative dazu wird in der DE 10 2012 220 126 A1 eine Anbringung der Feldformvorrichtung in einem auf Raumtemperatur befindlichen Bereich der Magnetanordnung vorgeschlagen, damit die Komponenten der Feldformvorrichtung im Betriebszustand von außen gut zugänglich sind und ohne eine Aufwärmung des Magnetspulensystems modifiziert werden können.

Als alternative Lösung wird in der eingangs zitierten JP 3737636 B2 vorgeschlagen, die Feldformvorrichtung auf das Innenrohr des Stickstoffbehälters zu kleben, welcher den He-Behälter umgibt. Dieses Innenrohr hat die Aufgabe, die Strahlung des Raumtemperaturinnenrohrs vom He-Behälter fernzuhalten und wird deshalb im Folgenden auch Strahlungsschildinnenrohr genannt. Bei geeigneter Konstruktion des Kryostaten ist dann nach einem ersten Magnettest nur noch ein Aufwärmen, nicht aber eine komplette Zerlegung des Kryostaten für das Anbringen der Feldformvorrichtung erforderlich.

Diese scheinbar ideale Lösung hat aber leider einen großen Nachteil, der von den Autoren der JP 3737636 B2 offenbar übersehen wurde: Der Stickstoffbehälter bewegt sich nämlich bei Änderungen des Stickstoff-Füllstands und mit ihm natürlich auch das Innenrohr mit der aufmontierten Feldformvorrichtung. Diese Bewegung hat nun aber eine ganz erhebliche Schwankung der Magnetfeldhomogenität im Arbeitsvolumen zur Folge, die in vielen Anwendungsfällen nicht akzeptiert werden kann.

### Aufgabe der Erfindung

Der vorliegenden Erfindung liegt demgegenüber die Aufgabe zugrunde, in einer NMR-Apparatur mit supraleitender Magnetanordnung und Feldformvorrichtung der eingangs definierten Art die Magnetfeldhomogenität im Arbeitsvolumen mit einfachen technischen Maßnahmen und ohne Volumenzunahme der Magnetanordnung wesentlich zu erhöhen, wobei die Feldformvorrichtung -etwa für Nachrüstungen oder zu Justagezwecken- auch ohne ein aufwändiges Zerlegen des Kryostaten, insbesondere des He-Behälters, oder der Magnetanordnung von außen her leicht zugänglich sein soll.

### Kurze Beschreibung der Erfindung

Diese Aufgabe wird auf ebenso überraschend einfache wie wirkungsvolle Weise gelöst durch eine NMR-Apparatur der eingangs genannten Art, die dadurch gekennzeichnet ist, dass die Feldformvorrichtung derart im Raum zwischen dem He-Innenrohr und dem Strahlungsschildinnenrohr befestigt ist, dass sie in einem starren mechanischen Kontakt mit dem He-Behälter steht, ohne dabei das Strahlungsschildinnenrohr zu berühren. Durch die vorliegende Erfindung werden die oben genannten Nachteile des Standes der Technik also vermieden, indem die Feldformvorrichtung mechanisch vom Stickstoffbehälter entkoppelt aber außerhalb des He-Behälters platziert wird.

**Weitere Vorteile gegenüber dem Stand der Technik:**

Da das supraleitende Magnetspulensystem ebenfalls starr mit dem He-Behälter verbunden ist, wird die relative Bewegung der Feldformvorrichtung zum supraleitenden Magnetspulensystem unterbunden, wodurch die Homogenität im Arbeitsvolumen stabil bleibt.

Ein guter thermischer Kontakt der Feldformvorrichtung mit dem He-Behälter ist nicht zwingend nötig, da sich ihre Temperatur auch ohne thermischen Kontakt mit dem He-Behälter durch die kombinierte Strahlung des He-Innenrohrs und des Strahlungsschildinnenrohrs einstellt. Beide Innenrohre sind im Betriebszustand auf sehr konstanter kryogener Temperatur, weshalb die Temperatur der Feldformvorrichtung ebenfalls hochstabil bleibt.

Dadurch wird eine Fülle von verschiedenen Befestigungsmöglichkeiten der Feldformvorrichtung mit dem He-Behälter ermöglicht. Die hierbei verwendeten Materialien müssen nicht unbedingt eine gute Wärmeleitfähigkeit haben. Auch thermisch schlechte Kontaktflächen sind zulässig, so lange die starre mechanische Verbindung mit dem He-Behälter gewährleistet ist.

### Bevorzugte Ausführungsformen und Weiterbildungen der Erfindung

In den meisten Kryostaten ist das Strahlungsschildinnenrohr mechanisch starr und in thermischem Kontakt mit einem Behälter mit flüssigem Stickstoff befestigt. Der thermische Kontakt gibt dem Strahlungsschildinnenrohr seine tiefe Temperatur. Diese tiefe Temperatur ist entscheidend für kleine Strahlungseinträge in den He-Behälter, womit die He-Verluste minimiert werden.

In anderen Kryostaten wird das Strahlungsschildinnenrohr durch einen thermischen Kontakt mit einem Kryokühler auf seine Betriebstemperatur gebracht. Diese Temperatur kann noch tiefer liegen als diejenige des flüssigen Stickstoffs, was die He-Verluste zusätzlich reduziert. Solche Kryostaten haben zudem den Vorteil, dass sie kein Volumen für den flüssigen Stickstoff benötigen, was das Design von kompakteren Kryostaten ermöglicht.

Vorteilhaft in einer erfindungsgemäßen NMR-Apparatur ist auch eine Feldformvorrichtung, die einen zylindrischen Körper aus weichmagnetischem Material enthält. Ein solcher Körper hat die ideale Form, um zwischen He-Innenrohr und Strahlungsschildinnenrohr positioniert zu werden. Auch die Herstellung eines solchen Körpers ist relativ einfach.

Nicht-zylindersymmetrische Aussparungen im zylindrischen Körper haben den Vorteil, eine große Flexibilität für das Shimmen des Magnetfeldes im Arbeitsvolumen zu bieten. Diese Aussparungen können durchgehend sein oder nicht. Durchgehende Aussparungen sind einfacher zu produzieren, nicht durchgehende Aussparungen geben aber mehr Spielraum für das Design der Feldformvorrichtung.

Die erfindungsgemäß vorgeschriebene Feldformvorrichtung muss so angeordnet sein, dass ihre Position bezüglich des supraleitenden Magnetspulensystems stets wohldefiniert und im Betriebszustand zeitlich konstant bleibt. Für die Realisierung dieser Bedingung gibt es mehrere Möglichkeiten:

Eine Möglichkeit ist die Verwendung eines Stützrohrs, mittels dessen mindestens Teile der Feldformvorrichtung positioniert sind. In der Regel bestehen diese Teile aus einem oder mehreren Zylindern mit oder ohne Aussparungen. Vorzugsweise sind sie mit dem Stützrohr mechanisch gut verbunden. Bei Vertikalsystemen kann das Eigengewicht diese mechanische Verbindung sein. Bei Zylindern mit Aussparungen ist auch deren Orientierung wichtig. Eine formschlüssige Verbindung kann dafür eine Lösung sein.

Alternativ dazu kann das Stützrohr auch mit dem Zylinder/den Zylindern gelötet oder verklebt werden. Das Stützrohr kann beispielsweise mit dem Boden des He-Behälters verschraubt werden. Auch Lösungen mit einem Stützrohr auf jeder Seite der Feldformvorrichtung sind möglich.

Eine weitere Möglichkeit besteht darin, zumindest Teile der Feldformvorrichtung mittels eines Klemmmechanismus mit dem He-Innenrohr zu verbinden. Bei dieser Lösung kann auf ein Stützrohr verzichtet werden. Bei geeigneter Ausführung können diese Teile der Feldformvorrichtung bei Bedarf wieder ausgebaut werden.

Bei anderen Ausführungsformen der Erfindung können zumindest Teile der Feldformvorrichtung mit der Außenfläche des He-Innenrohres verklebt sein. Diese Lösung hat den Vorteil, dass diese Teile der Feldformvorrichtung mechanisch stabil bezüglich dem Magnetspulensystem positioniert sind. Es muss allerdings darauf geachtet werden, dass ein Klebstoff verwendet wird, der tieftemperaturtauglich ist.

Bei weiteren vorteilhaften Ausführungsformen der erfindungsgemäßen NMR-Apparatur enthält die Feldformvorrichtung mindestens eine Folie aus weichmagnetischem Material, die auf einem Trägerrohr angeordnet ist. Das Trägerrohr ist -wie das oben beschriebene Stützrohr- mechanisch mit dem He-Behälter verbunden. Jede Folie aus weichmagnetischem Material kann individuell gestaltet werden, was gegenüber einer Lösung mit einem oder mehreren Zylindern mehr Freiheit im Design gibt.

Besonders vorteilhaft lässt sich die Erfindung bei einem Magnetspulensystem einsetzen, das mindestens eine Spule enthält, die mit Hochtemperatursupraleiter-Material gewickelt ist. Bei Magneten mit Hochtemperatursupraleiter, insbesondere Bandleiter, ist nämlich die schlechte Homogenität ein großes Problem. Ein Grund liegt darin, dass die supraleitende Schicht bei diesen Leitern typischerweise mehrere Millimeter breit ist, so dass sich der supraleitende Strom inhomogen verteilen kann. Das führt dazu, dass größere Feldinhomogenitäten im Arbeitsvolumen entstehen können als bei traditionellen Tieftemperatursupraleitern, bei welchen die stromtragenden Filamente in der Regel einen Durchmesser von einigen Hundertstel Millimetern haben. Hinzu kommt die Tatsache, dass sich die elektrischen Kryo-Shims, die zur Verbesserung der Homogenität eingesetzt werden, radial weiter von der Magnetachse befinden als der Hochtemperatursupraleiter. Wenn sie mit Strom gespeist werden, wird im Hochtemperatursupraleiter ein Strom induziert, der das Magnetfeld der Shims im Arbeitsvolumen abschwächt. Damit sind die Kryo-Shims oft nicht mehr in der Lage, die Magnetfeldinhomogenität im Arbeitsvolumen zu kompensieren und es muss nach alternativen Lösungen gesucht werden.

Bevorzugt ist auch eine Ausführungsform, bei der das Magnetspulensystem eine aktive Abschirmung besitzt. Diese aktive Abschirmung reduziert das Streufeld der Magnetanordnung, so dass im Labor mehr Platz für andere Anwendungen zur Verfügung steht.

Vorteilhaft ist auch eine Ausführungsform der erfindungsgemäßen NMR-Apparatur, bei der die Feldformvorrichtung magnetisch vollständig gesättigt und rein axial (in einer Richtung entlang der z-Achse) magnetisiert ist. In dieser Situation ist die Berechnung des durch die Feldformvorrichtung produzierten Feldes besonders einfach und exakt.

Vorteilhaft ist auch eine Ausführungsform der erfindungsgemäßen NMR-Apparatur, bei der Teile der Feldformvorrichtung einer Oberflächenbehandlung unterzogen wurden, insbesondere dass diese verzinkt wurden. Diese Oberflächenbehandlung bietet einen optimalen Schutz vor Korrosion, was insbesondere für Teile aus Weicheisen unerlässlich ist.

Eine besonders bevorzugte Ausführungsform der erfindungsgemäßen NMR-Apparatur zeichnet sich dadurch aus, dass die Feldformvorrichtung mehrere Elemente aus magnetischem Material umfasst. Dadurch bieten sich mehr Freiheitsgrade für die Optimierung der Feldformvorrichtung.

In den Rahmen der vorliegenden Erfindung fällt auch ein Verfahren zur Herstellung einer NMR-Apparatur der oben beschriebenen erfindungsgemäßen Art, welches sich dadurch auszeichnet, dass mindestens ein Teil der nicht-zylindersymmetrischen Aussparungen durch Funkenerosion abgetragen wird. Mit Funkenerosion kann hohe mechanische Genauigkeit erreicht werden.

Alternativ dazu kann bei einer anderen Verfahrensvariante vorgesehen sein, dass mindestens ein Teil der nicht-zylindersymmetrischen Aussparungen durch einen ätzenden Stoff abgetragen wird. Durch geeignetes Abdecken von Stellen der Feldformvorrichtung, die nicht nachbearbeitet werden müssen, kann mit einem Ätzverfahren in einem Säurebad auf einfache Weise Material abgetragen werden. Die Ätzzeit muss so eingestellt werden, dass die korrekte Dicke an Material abgetragen wird.

Eine weitere Alternative stellt eine Verfahrensvariante dar, bei welcher mindestens ein Teil der nicht-zylindersymmetrischen Aussparungen durch Elektrolyse abgetragen wird. Anstelle eines Säurebades wie bei der obigen Verfahrensvariante wird hier ein Elektrolytbad eingesetzt.

Schließlich kann bei einer weiteren Verfahrensvariante mindestens ein Teil der nicht-zylindersymmetrischen Aussparungen auch mittels Schleifen oder Fräsen abgetragen werden. Schleifen und Fräsen sind uralte Verfahren, die jeder Feinmechaniker beherrscht. Man benötigt zudem keine besonderen apparativen Einrichtungen für die Durchführung dieser Prozesse.

Bei Ausführungsformen der erfindungsgemäßen NMR-Apparatur, die nicht-zylindersymmetrischen Aussparungen in Form von durchgängigen Löchern durch die Feldformvorrichtung aufweisen, können die Löcher auch mit einem Laserstrahl herausgeschnitten werden. Ein wesentlicher Vorteil der Laser-Methode besteht in der sehr hohen mechanischen Präzision, so dass auch komplizierte vorgegebene Formen äußerst genau hergestellt werden können.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert. Es zeigen:

Fig. 1     einen schematischen Vertikalschnitt durch eine radiale Hälfte der erfindungsgemäßen NMR-Apparatur, bei der die Feldformvorrichtung mittels eines Stützrohrs mit dem Boden des Heliumbehälters fixiert ist

Fig. 2     ein Stützrohr mit einer Feldformvorrichtung ;

Fig. 3     einen schematischen Vertikalschnitt durch eine radiale Hälfte der erfindungsgemäßen NMR-Apparatur, bei der die Feldformvorrichtung mittels eines Klemmmechanismus mit dem He-Innenrohr fixiert ist;

Fig. 4     einen schematischen Vertikalschnitt durch eine radiale Hälfte der erfindungsgemäßen NMR-Apparatur, bei der die Feldformvorrichtung Folien enthält, die auf einem Trägerrohr liegen, welcher mit dem Boden des Heliumbehälters fixiert ist;

Fig. 5     einen schematischen Vertikalschnitt durch eine radiale Hälfte der erfindungsgemäßen NMR-Apparatur mit einem He-Behälter, einem Strahlungsschildbehälter und einem Behälter mit flüssigem Stickstoff;

Fig. 6     einen schematischen Vertikalschnitt durch eine radiale Hälfte der erfindungsgemäßen NMR-Apparatur mit einem He-Behälter und einem Strahlungsschildbehälter, welcher mit einem Kryokühler auf seine Betriebstemperatur gebracht wird;

Fig. 7     eine Feldformvorrichtung mit durchgängigen Aussparungen; und

Fig. 8     eine Feldformvorrichtung mit nicht-durchgängigen Aussparungen.

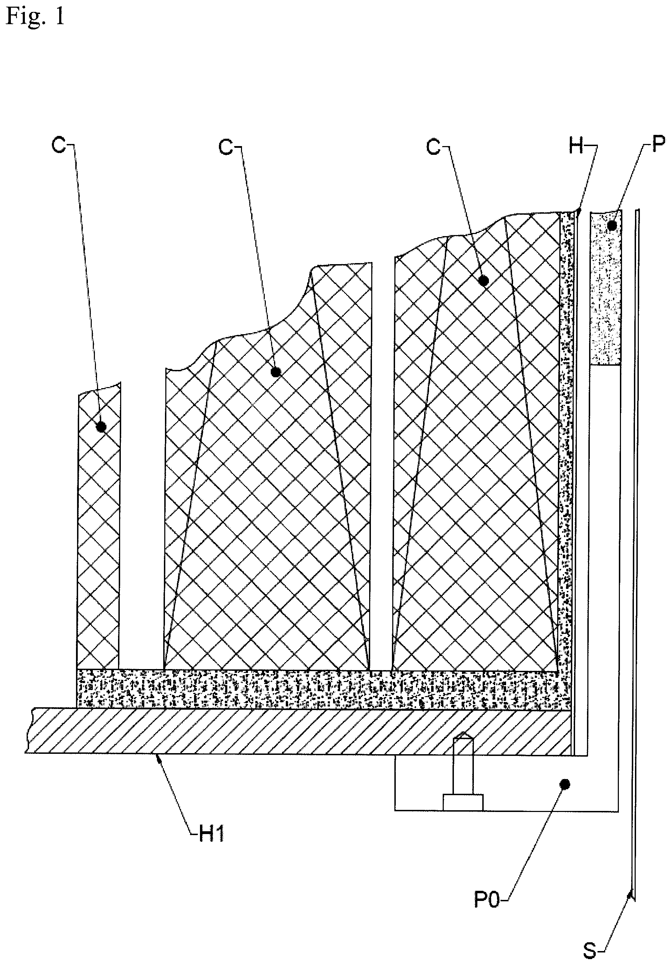

Die Figur 1 zeigt einen schematischen Vertikalschnitt durch eine radiale Hälfte der erfindungsgemäßen NMR-Apparatur, bei der die Feldformvorrichtung P mittels eines Stützrohrs P0 mit dem Boden des Heliumbehälters fixiert ist. Das supraleitende Magnetspulensystem C ist mechanisch starr mit dem Boden des He-Behälters H1 verbunden. Das Stützrohr P0 kann beispielsweise mit dem Boden des He-Behälters verschraubt oder verklebt werden. Die Schraubverbindung ist allerdings vorteilhafter, weil sie wieder gelöst werden kann. Die Feldformvorrichtung P kann mit dem Stützrohr P0 gelötet oder geklebt werden. Auch ein Bajonettverschluss ist denkbar. Alternativ kann die Feldformvorrichtung P zwischen zwei Stützrohren eingeklemmt werden.

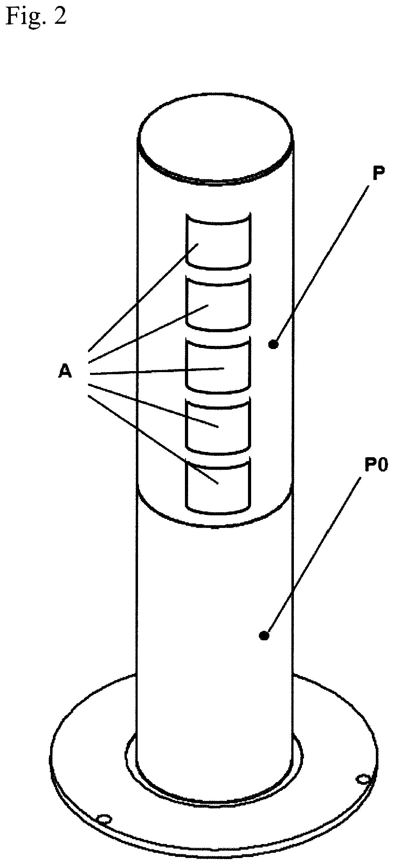

In der Figur 2 sind ein Stützrohr P0 und eine Feldformvorrichtung P vor dem Einbau dargestellt. Die Feldformvorrichtung P ist in diesem Beispiel ein Zylinder mit Aussparungen A.

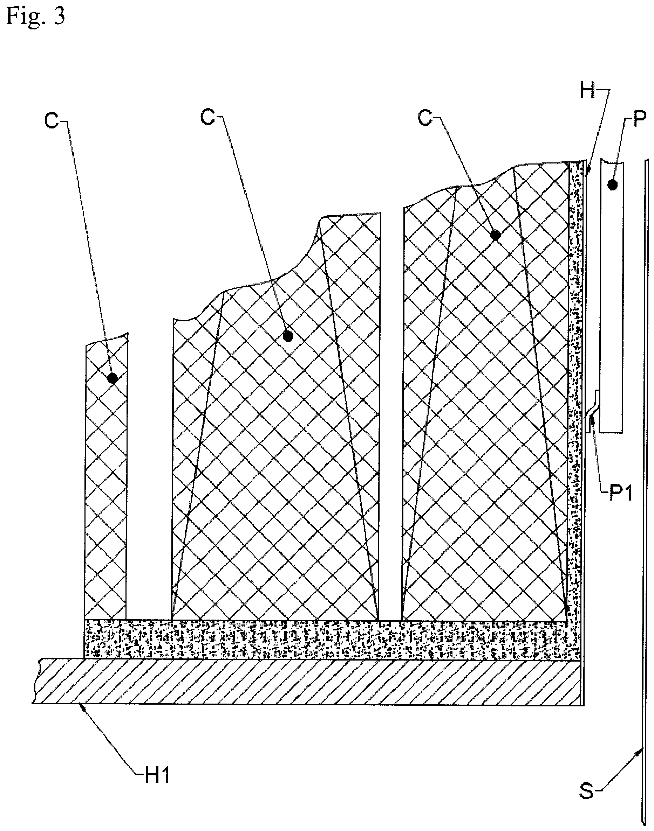

Die Figur 3 zeigt einen schematischen Vertikalschnitt durch eine radiale Hälfte der erfindungsgemäßen NMR-Apparatur, bei der die Feldformvorrichtung P mittels eines Klemmmechanismus P1 mit dem He-Innenrohr H fixiert ist. In dieser Anordnung ist kein Stützrohr erforderlich. Der Klemmmechanismus P1 kann entweder aus dem gleichen oder aus einem anderen Material als die Feldformvorrichtung P bestehen. Wenn das gleiche Material gewählt wird, können die Feldformvorrichtung P und der Klemmmechanismus P1 aus einem einzigen Werkstück gefertigt werden. Der Einfluss des Klemmmechanismus P1 auf die Magnetfeldhomogenität im Arbeitsvolumen muss aber beim Design der Feldformvorrichtung P berücksichtigt werden.

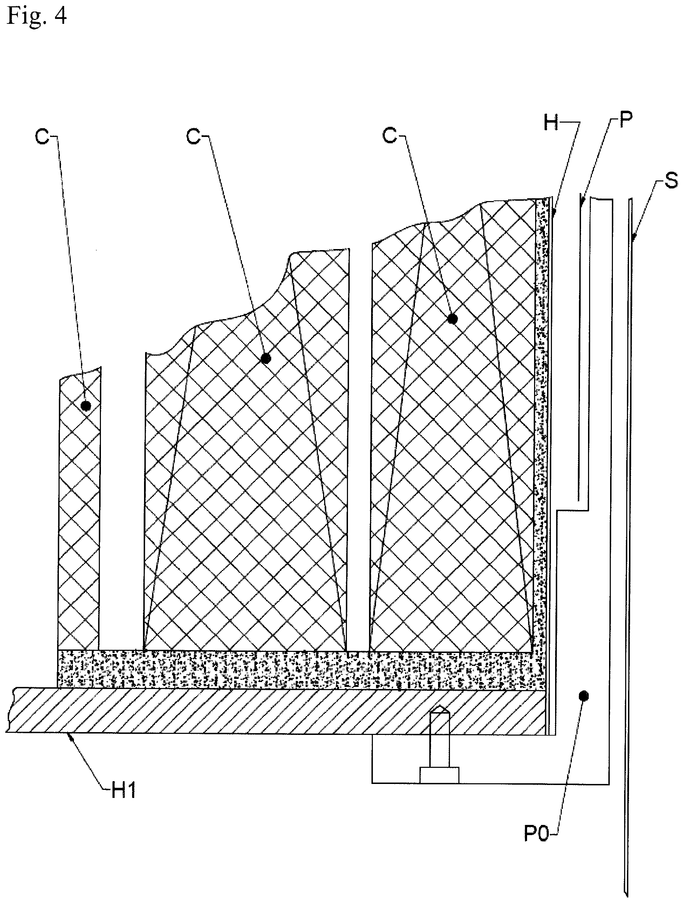

Die Figur 4 zeigt einen schematischen Vertikalschnitt durch eine radiale Hälfte der erfindungsgemäßen NMR-Apparatur, bei der die Feldformvorrichtung P Folien enthält, die auf einem Trägerrohr P0 liegen, welcher mit dem Boden des Heliumbehälters fixiert ist. Es können auch mehrere Folien übereinander auf das Trägerrohr angeordnet werden, vorzugsweise mit einem tieftemperaturtauglichen Klebeband. Die Folien können unterschiedliche Gestalten annehmen. Sie können zum Beispiel Löcher mit verschiedenen Mustern aufweisen. Sie können den ganzen Umfang des Trägerrohres oder nur einen Teil davon abdecken. Das Trägerrohr enthält vorzugsweise eine Eindrehung für das Anbringen von weichmagnetischer Folie. Damit ist sichergestellt, dass die weichmagnetische Folie beim Einführen des Trägerrohres unbeschädigt bleibt.

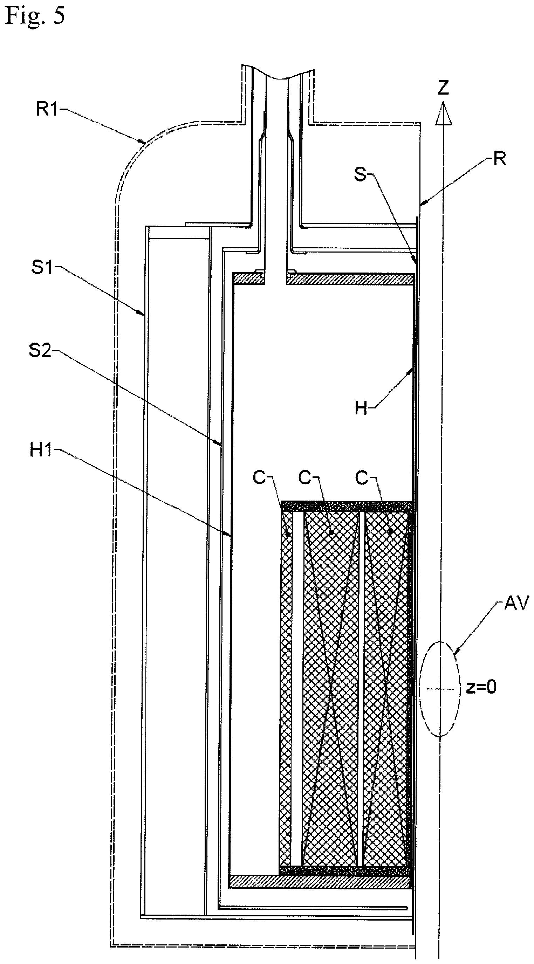

Die Figur 5 zeigt einen schematischen Vertikalschnitt durch eine radiale Hälfte der erfindungsgemäßen NMR-Apparatur mit einem supraleitenden Magnetspulensystem C, einem He-Behälter H1, einem Strahlungsschildbehälter S2 und einem Behälter S1 mit flüssigem Stickstoff. Das Strahlungsschildinnenrohr S gehört in diesem Fall nicht zum Strahlungsschildbehälter S2, sondern ist wärmeleitend mit dem Stickstoffbehälter S1 verbunden. Ein Raumtemperaturbehälter R1 mit Innenrohr R umgibt den Stickstoffbehälter S1. Im Betriebsfall herrscht in den Räumen zwischen den Behältern Vakuum. Die Symmetrieachse z des supraleitenden Magnetspulensystems C sowie das Arbeitsvolumen AV um die Ebene z=0 sind ebenfalls dargestellt.

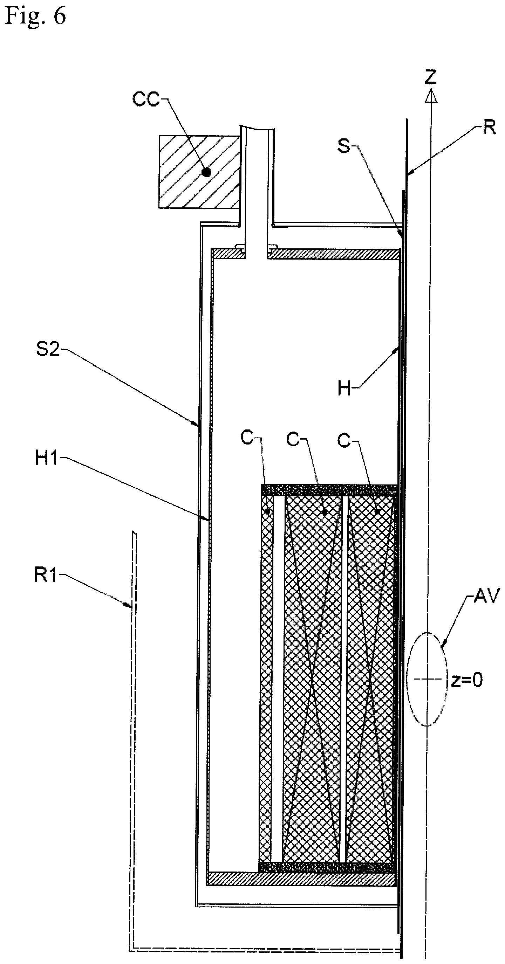

Die Figur 6 zeigt einen schematischen Vertikalschnitt durch eine radiale Hälfte der erfindungsgemäßen NMR-Apparatur mit einem supraleitenden Magnetspulensystem C, einem He-Behälter H1 und einem Strahlungsschildbehälter S2, welcher mit einem Kryokühler CC auf seine Betriebstemperatur gebracht wird. Der Strahlungsschildbehälter S2 ist thermisch verbunden mit einem Strahlungsschildinnenrohr S. Wie in der vorigen Figur werden auch der Raumtemperaturbehälter R1 mit Innenrohr R, die Symmetrieachse z sowie das Arbeitsvolumen AV um die Ebene z=0 gezeigt.

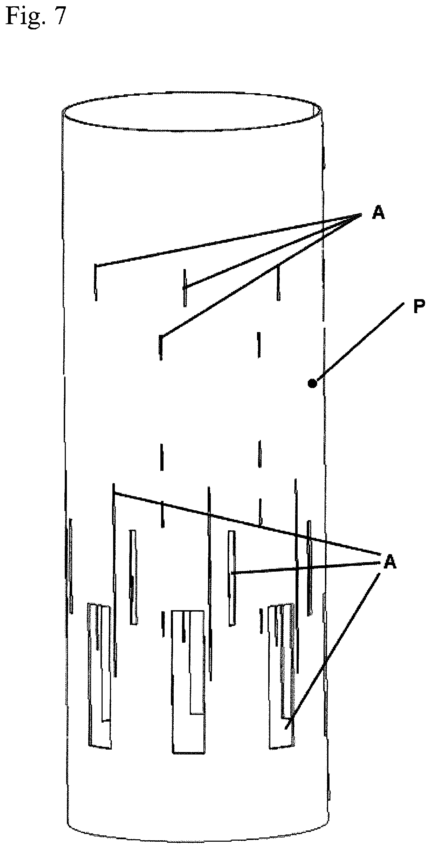

In der Figur 7 ist eine Feldformvorrichtung P mit durchgängigen Aussparungen A dargestellt. Die Aussparungen A werden in Form und Größe so bestimmt, dass das Magnetfeld im Arbeitsvolumen möglichst homogen wird.

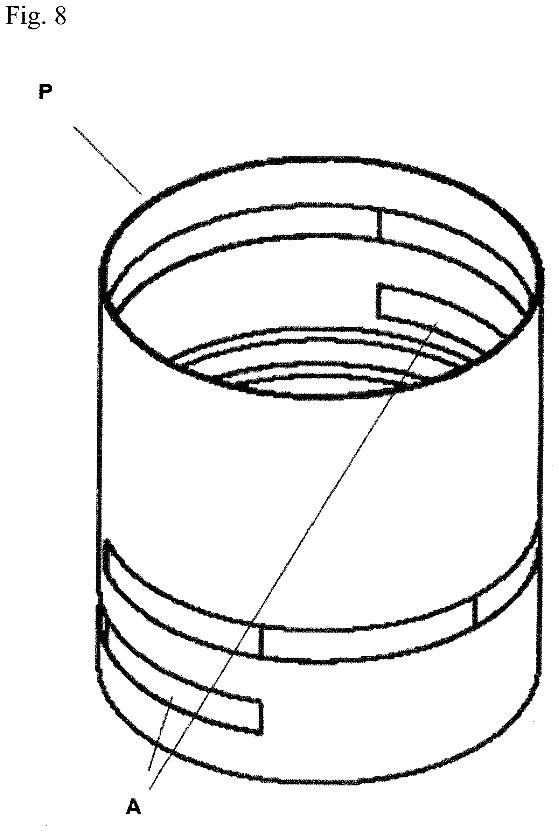

Schließlich zeigt die Figur 8 eine Feldformvorrichtung P mit nicht durchgängigen Aussparungen A. Diese können zum Beispiel mit einem Ätzverfahren oder durch Funkenerosion hergestellt werden.

**Bezugszeichenliste:**

| | |
|---|---|
| C | Magnetspulensystem |
| H | He-Innenrohr |
| H1 | He-Behälter |
| S | Strahlungsschildinnenrohr |
| S1 | Behälter mit flüssigem Stickstoff |
| S2 | Strahlungsschildbehälter |
| P | Feldformvorrichtung |
| P0 | Stützrohr, Trägerrohr |
| P1 | Klemmmechanismus |
| A | Aussparung |
| AV | Arbeitsvolumen |
| R | Raumtemperaturinnenrohr |
| R1 | Raumtemperaturbehälter |
| CC | Kryokühler |

**Patentansprüche**

1. NMR-Apparatur mit einem supraleitenden Magnetspulensystem (C) zur Erzeugung eines homogenen Magnetfeldes in Richtung einer z-Achse, wobei das Magnetspulensystem (C) in einem He-Behälter (H1) mit einem He-Innenrohr (H), der im Betrieb flüssiges Helium zur Kühlung der Spulen enthält, angeordnet und mechanisch starr mit dem He-Behälter (H1) verbunden ist, wobei ein Strahlungsschild mit einem Strahlungsschildinnenrohr (S) den He-Behälter (H1) zur Reduzierung der Verdampfungsrate des flüssigen Heliums mit Abstand umgibt, und wobei im Raum zwischen dem He-Innenrohr (H) und dem Strahlungsschildinnenrohr (S) eine Feldformvorrichtung (P) aus magnetischem Material zum Shimmen des homogenen Magnetfeldes angeordnet ist,
**dadurch gekennzeichnet,**
**dass** die Feldformvorrichtung (P) derart im Raum zwischen dem He-Innenrohr (H) und dem Strahlungsschildinnenrohr (S) befestigt ist, dass sie in einem starren mechanischen Kontakt mit dem He-Behälter (H1) steht, ohne dabei das Strahlungsschildinnenrohr (S) zu berühren.

2. NMR-Apparatur nach Anspruch 1, **dadurch gekennzeichnet, dass** das Strahlungsschildinnenrohr (S) mechanisch starr an sowie in thermischem Kontakt mit einem Behälter (S1) mit flüssigem Stickstoff befestigt ist.

3. NMR-Apparatur nach Anspruch 1, **dadurch gekennzeichnet, dass** ein Kryokühler (CC) vorhanden ist, mittels dessen das Strahlungsschildinnenrohr (S) durch thermischen Kontakt auf seine Betriebstemperatur gebracht werden kann.

4. NMR-Apparatur nach einem der vorhergehenden Ansprüche, **dadurch gekennzeichnet, dass** die Feldformvorrichtung (P) einen zylindrischen Körper aus weichmagnetischem Material enthält.

5. NMR-Apparatur nach Anspruch 4, **dadurch gekennzeichnet, dass** der zylindrische Körper der Feldformvorrichtung (P) nicht-zylindersymmetrische Aussparungen (A) aufweist.

6. NMR-Apparatur nach einem der vorhergehenden Ansprüche, **dadurch gekennzeichnet, dass** mindestens Teile der Feldformvorrichtung (P) mittels eines Stützrohrs (P0) positioniert sind.

7. NMR-Apparatur nach einem der vorhergehenden Ansprüche, **dadurch gekennzeichnet, dass** mindestens Teile der Feldformvorrichtung (P) mittels eines Klemmmechanismus (P1) mit dem He-Innenrohr (H) verbunden sind.

8. NMR-Apparatur nach einem der vorhergehenden Ansprüche, **dadurch gekennzeichnet, dass** mindestens Teile der Feldformvorrichtung (P) mit der Außenfläche des He-Innenrohres (H) verklebt sind.

9. NMR-Apparatur nach einem der vorhergehenden Ansprüche, **dadurch gekennzeichnet, dass** die Feldformvorrichtung (P) mindestens eine Folie aus weichmagnetischem Material enthält, die auf einem Trägerrohr (P0) angeordnet ist.

10. NMR-Apparatur nach einem der vorhergehenden Ansprüche, **dadurch gekennzeichnet, dass** das supraleitende Magnetspulensystem (C) mindestens eine Spule enthält, die mit Hochtemperatursupraleiter-Material gewickelt ist.

**Claims**

1. NMR apparatus having a superconducting magnet coil system (C) for generating a homogenous magnetic field in the direction of a z-axis, wherein the magnet coil system (C) is arranged in a He tank (H1) with a He inner tube (H), which in operation contains liquid helium for cooling the coils, and is mechanically rigidly connected to the He tank (H1), wherein a radiation shield with a radiation shield inner tube (S) encompasses the He tank (H1) at a distance in order to reduce the evaporation rate of the liquid helium, and wherein a field-shaping device (P) made from magnetic material is arranged in the space between the He inner tube (H) and the radiation shield inner tube (S) in order to shim the homogeneous magnetic field,
**characterized in that**
the field-shaping device (P) is fixed in the space between the He inner tube (H) and the radiation shield inner tube (S) in such a way that it is in rigid mechanical contact with the He tank (H1) without at the same time touching the radiation shield inner tube (S).

**2.** NMR apparatus according to claim 1, **characterized in that** the radiation shield inner tube (S) is fixed mechanically rigidly to and in thermal contact with a tank (S1) with liquid nitrogen.

**3.** NMR apparatus according to claim 1, **characterized in that** a cryocooler (CC) is provided, by means of which the radiation shield inner tube (S) can be brought to its operating temperature by thermal contact.

**4.** NMR apparatus according to one of the preceding claims, **characterized in that** the field-shaping device (P) contains a cylindrical body made from soft magnetic material.

**5.** NMR apparatus according to claim 4, **characterized in that** the cylindrical body of the field-shaping device (P) has non-cylindrically symmetrical cutouts (A).

**6.** NMR apparatus according to one of the preceding claims, **characterized in that** at least some parts of the field-shaping device (P) are positioned by means of a supporting tube (P0).

**7.** NMR apparatus according to one of the preceding claims, **characterized in that** at least some parts of the field-shaping device (P) are connected by means of a clamping mechanism (P1) to the He inner tube (H).

**8.** NMR apparatus according to one of the preceding claims, **characterized in that** at least some parts of the field-shaping device (P) are glued to the outer surface of the He inner tube (H).

**9.** NMR apparatus according to one of the preceding claims, **characterized in that** the field-shaping device (P) contains at least one foil made from soft magnetic material which is arranged on a carrier tube (P0).

**10.** NMR apparatus according to one of the preceding claims, **characterized in that** the superconducting magnet coil system (C) contains at least one coil which is wound with high-temperature superconductor material.

**Revendications**

**1.** Appareil de RMN comprenant un système de bobines magnétiques supraconductrices (C) destiné à produire un champ magnétique homogène dans la direction d'un axe z, dans lequel le système de bobines magnétiques (C) est disposé dans un réservoir de He (H1) avec un tube intérieur de He (H) qui, en fonctionnement, contient de l'hélium liquide destiné à refroidir les bobines, et relié mécaniquement de manière rigide au réservoir de He (H1), dans lequel un écran anti-rayonnement avec un tube intérieur d'écran anti-rayonnement (S) entoure à distance le réservoir de He (H1) pour réduire le taux d'évaporation de l'hélium liquide, et dans lequel un dispositif de formation de champ (P) en matériau magnétique destiné à shimmer le champ magnétique homogène est disposé dans l'espace entre le tube intérieur de He (H) et le tube intérieur d'écran anti-rayonnement (S),
**caractérisé en ce**
**que** le dispositif de formation de champ (P) est fixé dans l'espace entre le tube intérieur de He (H) et le tube intérieur d'écran anti-rayonnement (S) de manière à être en contact mécanique rigide avec le réservoir de He (H1), sans toutefois toucher le tube intérieur d'écran anti-rayonnement (S).

**2.** Appareil de RMN selon la revendication 1, **caractérisé en ce que** le tube intérieur d'écran anti-rayonnement (S) est fixé mécaniquement de manière rigide à un réservoir (S1) d'azote liquide et est en contact thermique avec celui-ci.

**3.** Appareil de RMN selon la revendication 1, **caractérisé en ce qu'**un cryorefroidisseur (CC) est présent, au moyen duquel le tube intérieur d'écran anti-rayonnement (S) peut être amené à sa température de fonctionnement par contact thermique.

**4.** Appareil de RMN selon l'une des revendications précédentes, **caractérisé en ce que** le dispositif de formation de champ (P) contient un corps cylindrique en matériau magnétique doux.

**5.** Appareil de RMN selon la revendication 4, **caractérisé en ce que** le corps cylindrique du dispositif de formation de champ (P) présente des évidements non à symétrie cylindrique (A).

**6.** Appareil de RMN selon l'une des revendications précédentes, **caractérisé en ce qu'**au moins des parties du dispositif de formation de champ (P) sont positionnées au moyen d'un tube de support (P0).

**7.** Appareil de RMN selon l'une des revendications précédentes, **caractérisé en ce qu'**au moins des parties du dispositif de formation de champ (P) sont reliées au tube intérieur de He (H) au moyen d'un mécanisme de serrage (P1).

**8.** Appareil de RMN selon l'une des revendications précédentes, **caractérisé en ce qu'**au moins des parties du dispositif de formation de champ (P) sont collées à la surface extérieure du tube intérieur de He (H).

**9.** Appareil de RMN selon l'une des revendications précédentes, **caractérisé en ce que** le dispositif de formation de champ (P) contient au moins une feuille en matériau magnétique doux qui est disposée sur un tube porteur (P0).

**10.** Appareil de RMN selon l'une des revendications précédentes, **caractérisé en ce que** le système de bobines magnétiques supraconductrices (C) contient au moins une bobine qui est enroulée avec un matériau supraconducteur à haute température.

Fig. 1

Fig. 2

Fig. 3

Fig. 4

## Fig. 5

Fig. 6

Fig. 7

Fig. 8

P

A

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 3737636 B
- US 6617853 B2
- DE 1016505 A1
- JP 4384220 B
- DE 102012220126 A1
- DE 10104054 C1